(19) **Europäisches Patentamt**
**European Patent Office**
**Office européen des brevets**

(11) **EP 1 760 822 A2**

(12) **EUROPEAN PATENT APPLICATION**

(43) Date of publication:
07.03.2007 Bulletin 2007/10

(51) Int Cl.:
*H01M 14/00* (2006.01)   *H01G 9/20* (2006.01)

(21) Application number: 06253536.4

(22) Date of filing: 06.07.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 05.09.2005 KR 20050082231

(71) Applicant: Samsung Electronics Co., Ltd.
Seoul 442-742 (KR)

(72) Inventors:
• Park, Young Jun c/o 308-604 Jugong Greenvil Apt.
Gyeonggi-do 443-370 (KR)

• Park, Sang Cheol c/o 234-1201 Family 2danji Apt.
Seoul 138 769 (KR)
• Nam, Jung Gyu c/o 102-1106 Samsung Apt.
Yongin-si, Gyeonggi-do 449-737 (KR)
• Kim, Ha Jin
Suwon-si, Gyeonggi-do 443-400 (KR)

(74) Representative: Kyle, Diana
Elkington and Fife LLP,
Prospect House,
8 Pembroke Road
Sevenoaks,
Kent TN13 1XR (GB)

(54) **Photoelectrochemical device and method using carbon nanotubes**

(57) A photoelectrochemical device and method using carbon nanotubes (206) comprise highly electrically conductive carbon nanotubes formed at an interface between a transparent electrode (201) and a metal oxide layer (207). According to the photoelectrochemical device and method, the interface resistance, which is caused due to an incomplete contact at the interface, is lowered and thus the electron mobility is improved, leading to high power conversion efficiency.

EP 1 760 822 A2

**Description**

The present invention relates to a photoelectrochemical device and method using carbon nanotubes, and more specifically to a photoelectrochemical device and method in which highly electrically conductive carbon nanotubes are formed at an interface between a transparent electrode and a metal oxide layer.

Generally, photoelectrochemical devices refer collectively to cells in which electrochemical reactions occur upon being irradiated with light to create a potential between two electrodes. The type of photoelectrochemical devices can generally be divided into photovcltaic cells and photoelectrolytic cells. For example, representative photovoltaic cells include dye-sensitized solar cells. Such dye-sensitized solar cells are photoelectrochemical solar cells that consist essentially of photosensitive dye molecules capable of absorbing visible rays to form electron-hole pairs and a transition metal oxide for transferring the generated electrons.

Various dye-sensitized solar cells have hitherto been developed. Of these, a representative dye-sensitized solar cell was reported by Gratzel et al. in Switzerland in 1991. The solar cell developed by Gratzel et al. comprises a semiconductor electrode composed of titanium dioxide nanoparticles covered with dye molecules, a counter electrode (e.g., a platinum electrode) and an electrolyte filled between the electrodes. Since this solar cell is fabricated at low costs per electric power generated when compared to conventional silicon cells, it has received a great deal of attention due to its possibility of replacing conventional solar cells.

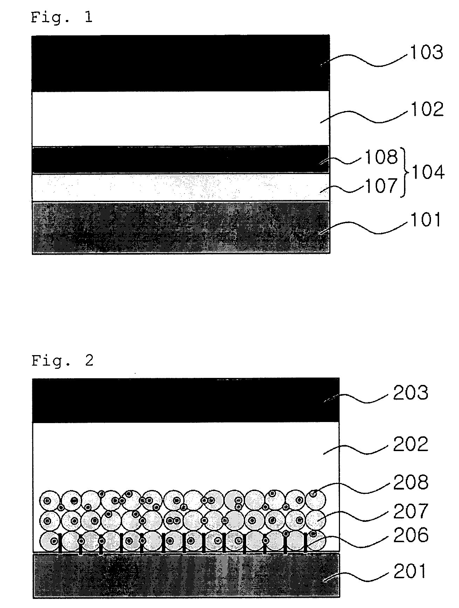

The structure of a conventional dye-sensitized solar cell is shown in Fig. 1. Referring to Fig. 1, the dyesensitized solar cell comprises a transparent electrode 101, a light-absorbing layer 104, an electrolyte 102 and a counter electrode 103. The light-absorbing layer 104 includes a metal oxide 107 and a dye 108.

The dye 108 included in the light-absorbing layer 104 may show a neutral state (5), a transition state (S) and an ionic state (Si) When sunlight is incident on the dye 108, the dye molecules undergo electronic transitions from the ground state (S/Si) to the excited state (5*/5+) to form electron-hole pairs, and the excited electrons are injected into a conduction band (CB) of the metal oxide 107 to generate an electromotive force.

However, all of the excited electrons are not 10 transferred to the conduction band of the metal oxide 107, but some electrons are bonded with the dye molecules to return to the ground state and some electrons transferred to the conduction band cause recombination reactions, e.g., participation in redox coupling within the electrolyte, to lower the power conversion efficiency, which becomes a cause of reduction in electromotive power. Thus, inhibition of such recombination reactions is considered significant in improving the electrical conductivity of electrodes to increase the power conversion efficiency of solar cells.

In particular, when the metal oxide layer is formed of nanoparticles, interfaces formed between the nanoparticles act as resistors, thus lowering the electrical conductivity and the power conversion efficiency of the cell. That is, in the case where metal oxide nanoparticles are printed or directly grown on the transparent electrode, an interface is formed between the two layers, resulting in an increase in electrical resistance. This increased electrical resistance causes recombination reactions of electrons, which are explained above, leading to a decrease in the power conversion efficiency of the cell.

In this connection, U.S. Patent No. 5,350,644 discloses a photovoltaic cell comprising a metal oxide layer doped with a bivalent or trivalent metal ion. According to this technique, however, since an interlayer interface is 10 unavoidably formed, an increase in electrical resistance is caused, thus making it impossible to efficiently control the recombination reactions of electrons. Accordingly, deterioration in the power conversion efficiency of the cell is inevitable.

Thus, there exists a need for a novel method for modifying the state of an interface formed between a transparent conductive substrate and a metal oxide layer to decrease the resistance at the interface so that the recombination reactions of electrons can be inhibited, which leads to an increase in power conversion efficiency.

Therefore, the present invention has been made in view 25 of the above problems of the prior art, and exemplary embodiments of the present invention provide a photoelectrochemical device with improved power conversion efficiency in which carbon nanotubes are formed at the interface between a transparent electrode and a metal oxide layer to decrease the resistance at the interface.

In accordance with an exemplary embodiment of the present invention, a photoelectrochemical device comprises a transparent electrode, a metal oxide layer, a counter electrode and an electrolyte, wherein carbon nanotubes are disposed at the interface between the transparent electrode and the metal oxide layer.

The above and other aspects, features and other advantages of the present invention will be more clearly understood from the following detailed description taken in conjunction with the accompanying drawings, in which:

Fig. 1 is a cross-sectional view schematically showing 20 the structure of a conventional solar cell;
Fig. 2 is a cross-sectional view schematically showing the structure of an exemplary embodiment of a photoelectrochemical device according to the present invention;
Fig. 3 is a scanning electron micrograph ("SEM") showing a contact interface formed between a transparent electrode and a metal oxide layer of a device fabricated in Example 1 according to the present invention;

Fig. 4 is an enlarged scanning electron micrograph (SEM) of the contact interface shown in Fig. 3;
Fig. 5 shows photographs demonstrating a change in the color of a device fabricated in Example 1 according to the present invention; and
Fig. 6 shows photographs demonstrating a change in the color of a device fabricated in Example 2 according to the present invention.

Hereinafter, exemplary embodiments of the present invention will be described in detail with reference to the attached drawings such that the present invention can be easily put into practice by those skilled in the art. However, the present invent ion is not limited to the exemplary embodiments, but may be embodied in various forms.

In the drawings, thicknesses are enlarged for the purpose of clearly illustrating layers and areas. If it is mentioned that a layer, a film, an area, or a plate is placed, on a different element, it includes a case that the layer, film, area, or plate is placed right on the different element, as well as a case that another element is disposed therebetween. On the contrary, if it is mentioned that one element is placed right on another element, it means that no element is disposed therebetween.

It will be understood that, although the terms first, second, third etc. may be used herein to describe various elements, components, regions, layers and/or sections, these elements, components, regions, layers and/or sections should not be limited by these terms. These terms are only used. To distinguish one element, component, region, layer or section from another element, component, region, layer or section. Thus, a first element, component, region, layer or section discussed below could be termed a second element, component, region, layer or section without departing from the teachings of the present invention.

Spatially relative terms, such as "beneath", "below", "lower", "above", "upper" an the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that when an element such as a layer, film, region or substrate is referred to as being "on"another element, it can be directly on the other element or intervening elements may also be present. In contrast, when an element is referred to as being "directly on" another element, there are no intervening elements present.

A photoelectrochemical device of the present invention is characterized in that carbon nanotubes are formed at an interface between a transparent electrode and a metal oxide layer so that the device has decreased resistance at the interface and improved electron mobility, leading to an increase in power conversion efficiency.

Fig. 2 is a schematic cross-sectional view of an exemplary embodiment of a photoelectrochemical device according to the present invention. As shown in Fig. 2, the photoelectrochemical device comprises a transparent electrode 201 consisting of a substrate and a conductive material coated on the substrate, a metal oxide layer 207 disposed on the transparent electrode 201 and a dye 208 adsorbed on the surface of the metal oxide layer, carbon nanotubes 206 disposed at an interface between the transparent electrode 201and the metal oxide layer 207, a counter electrode 203 arranged opposite to the transparent electrode 201, and an electrolyte 202 filled into a space formed between the transparent electrode and the counter electrode.

Generally, when a metal oxide layer composed of metal oxide nanoparticles is formed on a transparent electrode, an incomplete interface contact is made between the transparent electrode and the metal oxide layer and thus interfaces formed between the nanoparticles and the transparent electrode act as resistors, resulting in low electrical conductivity. In contrast, since the photoelectrochemical device of the present invention comprises carbon nanotubes 206 formed at the interface between the transparent electrode 201 and the metal oxide layer 207, a contact resistance at the interface is decreased. Accordingly, after electrons generated from the dye 208 are injected into the metal oxide layer 207, the electrons readily migrate to the transparent electrode 201.

That is, an interface resistance inevitably occurs due to an incomplete contact between a metal oxide layer and a transparent electrode in conventional photoelectrochemical devices, whereas substantially no interface resistance occurs in the photoelectrochemical device of the present invention, thus facilitating the migration of electrons to the electrode 201. This increased electron mobility can inhibit accumulation and recombination reactions of the electrons.

Specifically, the carbon nanotubes 206 included in the photoelectrochemical device of the present invention are directly formed on a catalytic metal layer disposed between the transparent electrode 201 and the metal oxide layer 207 by chemical vapor deposition ("CVD") or plasma-enhanced chemical vapor deposition ("PECVD").

More specifically, a catalytic metal layer is formed to a predetermined thickness on the surface of the transparent electrode 201, which consists of a substrate and a conductive material coated on the substrate. The catalytic metal layer is formed by magnetron sputtering or e-beam evaporation, so that the carbon nanotubes 206 can be grown on the surface of the transparent electrode 201.

Depending on the kind of the transparent electrode 201, a buffer layer may be formed on the transparent electrode 210 by magnetron sputtering or e-beam evaporation. Thereafter, a catalytic metal layer is formed on the buffer layer to grow the carbon nanotubes 206 thereon.

The catalytic metal layer is composed of a metal selected from the group consisting of nickel, iron, cobalt, palladium, platinum, and alloys thereof. The catalytic metal layer preferably has a thickness of about 0.5 nm to about 10 nm.

The buffer layer formed under the catalytic metal layer is composed of a metal selected from the group consisting of aluminum (Al), titanium (Ti), chromium (Cr), and niobium (Nb). The buffer layer preferably has a thickness of about 0.5 nm to about 50 nm.

Next, a carbon-containing gas, such as methane, acetylene, ethylene, carbon monoxide or carbon dioxide, is fed along with $H_2$, $N_2$ or Ar gas into a reactor at about 350°C to about 900°C to grow the carbon nanotubes 206 in a direction perpendicular to the surface of the catalytic metal layer.

The transparent electrode 201 used in the photoelectrochemical device of the present invention is formed by coating an electrically conductive material on a substrate.

The substrate may be of any type so long as it is transparent. Specific examples of the substrate include transparent plastic substrates and organic substrates. Exemplary conductive materials that can be coated on the substrate include indium tin oxide (ITO), fluorine-doped tin oxide (FTO), $ZnO-Ga_2O_3$, $ZnO-Al_2O_3$, and $SnO_2-Sb_2O_3$, for example.

The electrolyte 202 used in the photoelectrochemical device of the present invention is composed of an electrolytic solution, for example, a solution of iodine in acetonitrile, an N-methyl-2-pyrrolidone (NNP) solution, or a 3-methoxypropionitrile solution. Any electrolytic solution may be used, without limitation, so long as it exhibits hole conductivity.

The counter electrode 203 used in the 20 photoelectrochemical device of the present invention may be made of, without limitation, an electrically conductive material. So long as a conductive layer is disposed on the surface of the counter electrode 203 facing the transparent electrode 201. The counter electrode may be made of any insulating material. It is preferred to use an electrochemically stable material to constitute the counter electrode 203. Specific examples of preferred electrochemically stable materials include platinum, gold and carbon.

For the purpose of improving the catalytic effects of oxidation and reduction, it is preferred that the surface of the counter electrode 203 facing the transparent electrode 201 have a microstructure with increased surface area. For example, the counter electrode 203 is preferably made of platinum black or porous carbon. The platinum black counter electrode 203 may be produced by anodic oxidation of platinum or treatment with hexachloroplatinate. The porous carbon counter electrode 203 may be produced by sintering of carbon fine particles or baking of an organic polymer.

The metal oxide layer 207 used in the photoelectrochemical device of the present invention is made of a metal oxide selected from the group consisting of, but not limited to, $TiO_2$, $ZnO$, $Nb_2O_5$, $WO_3$, $Sf0_2$ and $MgO$. $Ti0_2$ is preferred.

The application of the metal oxide to the substrate may be performed by screen printing, electrophoresis or spraying.

The metal oxide layer 207 preferably has a large surface area so that the dye 208 adsorbed on the surface of the metal oxide absorbs as much light as possible and the degree of adsorption to the electrolyte is increased. It is preferred that the metal oxide layer 207 be composed of nanomaterials, such as quantum dots, nanodots, nanotubes, nanowires, nanobelts or nanoparticles.

To increase the amount of electrons generated, the metal 5 oxide layer 207 may have a bilayer structure consisting of about a 10 pm to about a 15 pm-thick layer composed of metal oxide particles having a particle size of about 9 mu to about 30 nm and about a 5 pm to about a 10 pm-thick layer composed of metal oxide particles having a particle size of about 100 nm to about 500 nm. Alternatively, the metal oxide layer 207 may be about a 1 pm to about a 30 pm-thick monolayer composed of metal oxide particles having a particle size of about 100 nm to about 500 rim.

The photoelectrochemical device of the present invention comprises a dye 208 adsorbed on the surface of the metal oxide layer 207. The dye 208 absorbs light and undergoes electronic transitions from the ground state to the excited state to form electron-hole pairs. The excited electrons are injected into a conduction band (CB) of the metal oxide layer 207 and transferred to the electrode 201 to generate an electromotive force.

Any dye material that can be generally used in the field of photoelectrochemical devices may be used as the dye 208. Ruthenium complexes are preferably used as the dye 208. In addition to ruthenium complexes, any colorant may be used and the metal oxide layer, and any technique known in the art can be employed without particular limitation.

Hereinafter, the present invention will be explained in more detail with reference to the following examples.

However, these examples are given for the purpose of illustration and are not to be construed as limiting the scope of the invention.

Example 1

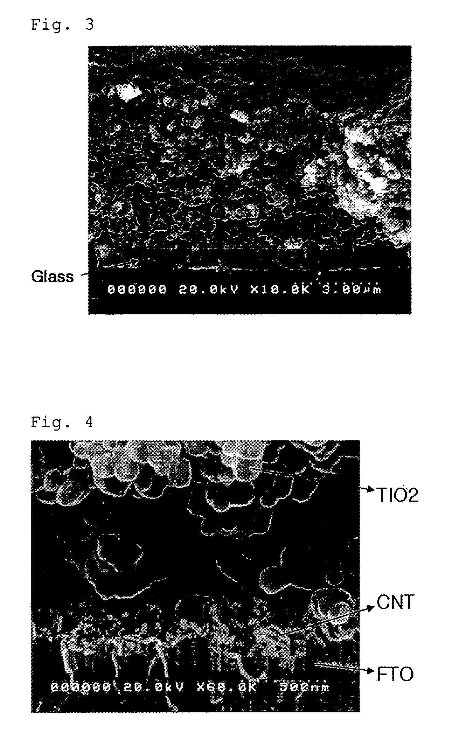

Fluorine-doped tin oxide (FTO) was applied to a glass substrate using a sputter, and then an aluminum buffer layer was formed to a thickness of 10 nm thereon by e-beam evaporation. A catalyst layer composed of Invar (Ni:Fe: Co-42:52:6 (w/w/w)) was formed to a thickness of 2 rim on the buffer layer. Subsequently, a 15 pm-thick layer composed of $TiO_2$ particles having a particle size of 9 nm and a 5 pm-thick layer composed of $TiO_2$ particles having a particle size of 300 nm were laminated on the catalyst layer, followed by printing and baking at 500CC for one hour. Next, acetylene and argon were supplied to a reactor at 500°C and reacted with the catalytic metal layer for 10 minutes in the reactor to form carbon nanotubes on the surface of the catalytic metal layer. An interface formed between the transparent electrode and the metal oxide layer, at which carbon nanotubes were formed, is shown in Figs. 3 and 4. Fig. 4 is an enlarged image of the without particular limitation if the colorant has charge separation functions and exhibits sensitizing functions. Suitable colorants include, for example: xanthene type colorants, such as Rhodamine B, Rose Bengal, eosin and erythrosine; cyanine type colorants, such as quinocyanine and cryptocyanine; basic dyes, phenosafranine, Capri blue, thiosine, and Methylene Blue; porphyrin type compounds, such as chlorophyll, zinc porphyrin, and magnesium porphyrin; azo colorants; phthalocyanine compounds; complex compounds, such as Ru trisbipyridyl; anthraquinone type colorants; polycyclic quinine type colorants; and the like. These colorants may be used alone or in combination of two or more of the colorants. As the ruthenium complexes, there can be used $RuL_2(SCN)_2$, $RuL_2(H_2O)_2$, $RuL_3$, and $RuL_2$ (wherein L is 2,2'-bipyridyl-4,4'-dicarboxylate, etc.).

On the other hand, the photoelectrochemical device of the present invention exhibits the same operational characteristics as a solar cell, and at the same time, electrochromic effects in response to an applied current flow, which enables the photoelectrochemical device to be applied as an electrochrotnic device.

No special apparatus or process is needed for the fabrication of the photoelectrochemical device according to the present invention, except the formation of carbon nanotubes at the interface between the transparent electrode contact interface shown in Fig. 3. The images shown in Figs. 3 and 4 demonstrate that the carbon nanotubes are formed at the contact interface between transparent electrode and the metal oxide layer.

Subsequently, the resulting structure was dipped in a 0.3 mM ruthenium dithiocyanate 2,2'-bipyridyl-4,4' dicarboxylate solution for 24 hours, and dried to adsorb the dye on the surface of the $TiO_2$ layer. A platinum counter electrode was formed, and then an electrolytic solution was filled into a space formed between the two electrodes (i.e., the transparent and counter electrodes) through a hole penetrating the counter electrode, completing the fabrication of a device. As the electrolytic solution, an 13/I solution of 0.6 moles of 1,2-dimethyl-3-octyl-imidazolium iodide, 0.2 moles of Lii, 0.04 moles of 12 and 0.2 moles of 4-tert-butyl pyridine in acetonitrile was used.

Example 2

A device was fabricated in the same manner as in Example 20 1, except that a 5 pm-thick $TiO_2$ monolayer composed of $TiO_2$ particles having a particle size of 300 nm was formed.

Comparative Example 1

A device was fabricated in the same manner as in Example 2, except tha carbon nanotubes were not formed.

To measure the power conversion efficiency of the devices fabricated in Examples 1 and 2 and Comparative Example 1, the photovoltages and photocurrents of the devices were

$$\eta_e \ = \ (V_{oc} \cdot I_{sc} \cdot FF)/(P_{inc})$$

where $P_{inc}$ is 100 mw/cm$^2$ (1 sun).

The obtained results are shown in Table 1.

**Table 1**

| Example No. | $I_{sc}$ (mA/cm$^2$) | $V_{oc}$ (mV) | FF | Power conversion efficiency (%) |
|---|---|---|---|---|
| Example 1 | 24.032 | 2141.622 | 0.226 | 11.319 |
| Example 2 | 8.550 | 1176.48 | 0.374 | 10.223 |
| Comparative Example 1 | 5.55 | 560.89 | 0.521 | 0.518 |

measured. For the measurements, a xenon lamp (01193, Oriel) was used as a light source, and a standard solar cell (Frunhofer Institute Solar Engeriessysteme, Certificate No. CISE369, Type of material: Mono-Si + KG filter) was used to compensate for the solar conditions (AM 1.5) of the xenon lamp. The current density ($I_{SC}$), voltage ($V_{OC}$) and fill factor (FF) of the devices were calculated from the obtained photocurrent-photovoltage curves. The power conversion efficiency ($\eta_e$) of the devices was calculated according to the following equation:

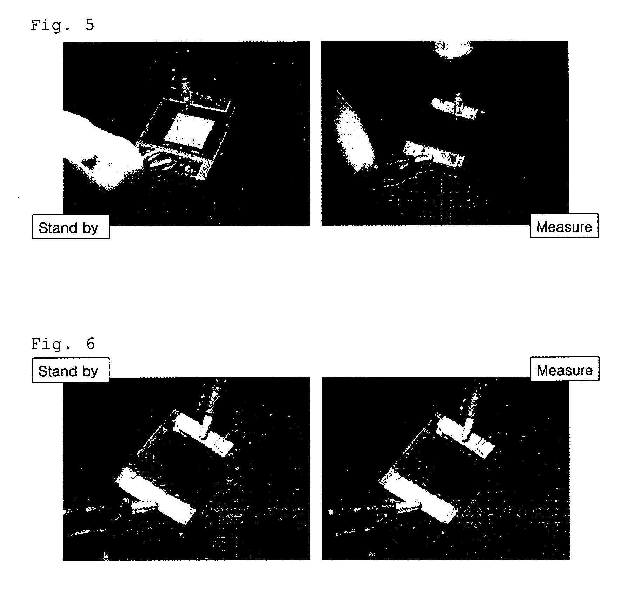

After a voltage was applied to both electrodes of each of the devices fabricated in Examples 1 and 2, changes in color were observed in order to evaluate the electrochromic effects of the devices. The results are shown in Figs. 5 and 6. It is obvious from the photographs shown in Figs. 5 and 6 that changes in color were distinctly observed in the devices whereas no change in color was observed in the device fabricated in Comparative Example 1.

As apparent from the above description, since the photoelectrochemical device of the present invention comprises highly electrically conductive carbon nanotubes formed at an interface between a transparent electrode and a metal oxide layer, the resistance at the interface is lowered and the migration of electrons is more facilitated, thus achieving high power conversion efficiency and superior electrochromic effects.

Although the exemplary embodiments of the present 15 invention have been disclosed for illustrative purposes, those skilled in the art will appreciate that various modifications and variations are possible. It is to be understood that such modifications are within the scope of the present invention.

**Claims**

**1.** A photoelectrochemical device comprising:

a transparent electrode (201) consisting of a substrate and a conductive material coated on the substrate;
a metal oxide layer (207) disposed on the transparent electrode (201);
a dye (208) adsorbed on the surface of the metal oxide layer (207);
carbon nanotubes (206) disposed at an interface between the transparent electrode (201) and the metal oxide layer (207);
a counter electrode (203) arranged opposite to the transparent electrode (201); and
an electrolyte (202) filled into a space formed between the transparent electrode (201) and the counter electrode (203).

**2.** The photoelectrochemical device according to claim 1, wherein the carbon nanotubes (206) are directly formed on a catalytic metal layer disposed by chemical vapor deposition (CVD) or plasma-enhanced chemical vapor deposition (PECVD).

**3.** The photoelectrochemical device according to claim 1 or 2, further comprising a buffer layer formed under the catalytic metal layer.

**4.** The photoelectrochemical device according to claim 2 or 3, wherein the catalytic metal layer is composed of a metal selected from nickel, iron, cobalt, palladium, platinum, and alloys thereof.

5. The photoelectrochemical device according to claim 2 or 3, wherein the catalytic metal layer is composed of a metal selected from nickel, iron, cobalt, palladium, platinum, and alloys thereof.

6. The photoelectrochemical device according to any of claims 3 to 5, wherein the buffer layer is composed of a metal selected from aluminum (Al), titanium (Ti), chromium (Cr), and niobium (Nb).

7. The photoelectrochemical device according to any of claims 1 to 6, wherein the substrate is a glass or a plastic substrate.

8. The photoelectrochemical device according to any of claims 1 to 7, wherein the conductive material coated on the substrate is selected from indium tin oxide (ITO), fluorine-doped tin oxide (FI'O), $ZnO-Ga_2O_3$, $ZnO-Al_2O_3$, and $SnO_2-Sb_2O_3$.

9. The photoelectrochemical device according to any of claims 1 to 8, wherein the electrolyte is selected from a solution of iodine in acetonitrile, an N-methyl-2-pyrrolidone (NNP) solution, and a 3-methoxypropionitrile solution.

10. The photoelectrochemical device according to claims 1 to 9, wherein the metal oxide layer is made of a metal oxide selected from $TiC_2$, ZnO, $Nb_2O_5$, $WO_3$, $SnO_2$, and MgO.

11. The photoelectrochemical device according to any of claims 1 to 10, wherein the metal oxide layer is formed by a coating technique selected from screen printing, electrophoresis, and spraying.

12. The photoelectrochemical device according to any of claims 1 to 11, wherein the metal oxide layer has a bilayer structure consisting of a 10~15 pm-thick layer composed of metal oxide particles having a particle size of 9 rim to 30 rim and a 5~1O pm-thick layer composed of metal oxide particles having a particle size of 100 nm to 500 nm.

13. The photoelectrochemical device according to any of claims 1 to 11, wherein the metal oxide layer is a 1--30 pm-thickmonolayer composed of metal oxide particles having a particle size of 100 nm to 500 nm.

14. The photoelectrochemical device according to any of claims 1 to 13, wherein the device exhibits photovoltaic properties.

15. The photoelectrochemical device according to any of claims 1 to 13, wherein the device exhibits electrochromic properties.

16. A method of forming a photoelectrochemical device,
the method comprising coating a conductive material on a substrate forming a transparent electrode; disposing a metal oxide layer (207) on the transparent electrode (201);
adsorbing a dye (208) on the surface of the metal oxide layer; disposing carbon nanottibes (206) at an interface between the transparent electrode and the metal oxide layer; arranging a counter electrode (203) opposite to the transparent electrode (201); and
filling an electrolyte (202) into a space formed between the transparent electrode (201) and the counter electrode (203).

17. The method according to claim 16, further comprising forming the carbon nanotubes directly on a catalytic metal layer disposed by chemical vapor deposition (CVD) or plasma-enhanced chemical vapor deposition (PECVD).

18. The method according to claim 16 or 17, further comprising forming a buffer layer under the catalytic metal layer.

19. The method according to claim 17 or 18, further comprising composing the catalytic metal layer of a metal selected from nickel, iron, cobalt, palladium, platinum, and alloys thereof.

20. The method according to claim 17 or 18, further comprising composing the buffer layer of a metal selected from aluminum (Al), titanium (Ti), chromium (Cr), and niobium (Nb).

21. The method according to any of claims 16 to 20, wherein the substrate is a glass or a plastic substrate.

22. The method according to any of claims 16 to 21, wherein the conductive material coated on the substrate is indium tin oxide (ITO), fluorine-doped (FTC), $ZnO-Ga_2O_3$, $ZnO-Al_2O_3$, or $SnO_2-Sb_2O_3$.

23. The method according to any of claims 16 to 22, wherein the electrolyte is selected from a solution of iodine in acetonitrile, an N-methyl-2-pyrrolidone (NMP) solution, and a 3-methoxypropionitrile solution.

24. The method according to any of claims 16 to 23, wherein metal oxide layer is selected from $TiO_2$, ZnO, $Nb_2O_5$, $WO_3$, $SnO_2$, and MgO.

25. The method according to any of claims 16 to 24 wherein the metal oxide layer by a coating technique selected from the group consisting of screen printing, electrophoresis, and spraying.

Fig. 1

Fig. 2

Fig. 3

Glass

000000 20.0kV X10.0K 3.00μm

Fig. 4

TIO2

CNT

FTO

000000 20.0kV X60.0K 500nm

Fig. 5

Stand by

Measure

Fig. 6

Stand by

Measure

**EP 1 760 822 A2**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5350644 A